# EUROPEAN PATENT APPLICATION

(11) **EP 4 668 059 A1**
(43) Date of publication of application: **24.12.2025**
(21) Application number: 25183399.2
(22) Date of filing: 17.06.2025
(51) Int. Cl.: G06F 1/20, H01L 23/367, H01L 23/473, H05K 7/20

(54) **LIQUID COOLING APPARATUS AND ELECTRONIC DEVICE**

(30) Priority: 18.06.2024 CN 202410787930
(71) Applicant: Bitdeer Semiconductor Technology PTE. LTD., 049514 Singapore (SG)
(72) Inventor: YANG, Senfeng, 049514 Singapore (SG); LI, Weiguo, 049514 Singapore (SG)
(74) Representative: Metida

(57) **Abstract**

Disclosed are a liquid cooling apparatus and an electronic device. The liquid cooling apparatus includes a housing. A medium outlet, a medium inlet, and a medium flow channel are arranged on the housing. A plurality of heat dissipation fins are spaced apart within the medium flow channel. A space between the medium outlet and the heat dissipation fins within the medium flow channel forms a confluence region, wherein a confluence structure is arranged within the confluence region. The confluence structure includes a first confluence plate and a second confluence plate oppositely and spacedly arranged in the width direction, wherein a distance between the first confluence plate and the second confluence plate increases along a direction from the medium outlet towards the heat dissipation fins; and in the extension direction, the confluence structure is spaced apart from the heat dissipation fins.

## Description

### TECHNICAL FIELD

The present disclosure relates to the technical field of liquid cooling, and in particular, relates to a liquid cooling apparatus and an electronic device.

### BACKGROUND

With advancements in technologies, an increasing number of electronic devices employ liquid cooling solutions to address heat dissipation issues. For instance, electronic devices used for high-performance computing, which contain numerous chips, exhibit substantial heat generation during operation of the chips. If this heat is not efficiently dissipated in a timely manner, the cumulated heat can adversely affect the performance and operational service time of the individual chips, and may even lead to device malfunctions or system crashes. In the prior art, although some solutions already utilize liquid cooling plates (cold plates) to dissipate heat from chips, and have even incorporated heat dissipation fins within flow channels of these liquid cooling plates, as exemplified a prior document CN115443053A, significant temperature differences still exist among chips along the width direction of the same flow channel. This still fails to meet the stringent requirements for temperature uniformity across chips in electronic devices designed for high computational loads.

### SUMMARY

In view of the above situation, the present disclosure is mainly intended to provide a liquid cooling apparatus and an electronic device, which are capable of enhancing the uniformity of flow velocity and temperature of a medium across a width direction of the flow channel, thereby improving temperature consistency (or uniformity) of chips at various positions and lowering temperatures of the chips on the entire circuit board.

To achieve the above objective, the present disclosure employs the following technical solutions:
In a first aspect, embodiments of the present disclosure provide a liquid cooling apparatus applicable to an electronic device, the electronic device including a circuit board and the liquid cooling apparatus; wherein the liquid cooling apparatus includes a housing, a medium inlet, a medium outlet, and a medium flow channel being arranged in the housing, wherein the medium flow channel is in communication with the medium inlet and the medium outlet, and a plurality of heat dissipation fins are spaced apart along a width direction of the medium flow channel within the medium flow channel, the heat dissipation fins extending along an extension direction of the medium flow channel; the circuit board includes a plurality of chips, wherein the plurality of chips are organized into a plurality of columns of chipsets arrayed along the width direction, each of the chipsets includes a plurality of said chips spaced apart along the extension direction; and the circuit board is mounted on at least one outer surface of the housing facing away from the medium flow channel, and each of the chips is in contact with a corresponding region of the medium flow channel; wherein a space between the medium outlet and the heat dissipation fins within the medium flow channel forms a confluence region, wherein a confluence structure is arranged within the confluence region, the confluence structure including a first confluence plate and a second confluence plate oppositely and spacedly arranged in the width direction, wherein a distance between the first confluence plate and the second confluence plate increases along a direction from the medium outlet towards the heat dissipation fins; and in the extension direction, the confluence structure is spaced apart from the heat dissipation fins, and a distance between each of the heat dissipation fins to the medium outlet increases from a central portion towards both sides in the width direction.

In some embodiments, end portions of the heat dissipation fins disposed on a same side of a center plane of the medium flow channel are connected to form a connecting surface, and the connecting surface is at least partially parallel to a confluence plate on a same side of the connecting surface.

In some embodiments, among the plurality of heat dissipation fins, two adjacent heat dissipation fins disposed at an edge of the medium flow channel in the width direction form a gap region therebetween; and ends of the first confluence plate and the second confluence plate close to the heat dissipation fins each face the gap region on their respective sides.

In some embodiments, end portions of the first confluence plate and the second confluence plate close to the medium outlet directly face an interior of the medium outlet, and end portions of the first confluence plate and the second confluence plate close to the heat dissipation fins are disposed outside both sides of the medium outlet.

In some embodiments, each of the first confluence plate and the second confluence plate includes a first plate segment and a second plate segment that are bent and connected, wherein the first plate segment is obliquely arranged relative to the extension direction and is closer to the medium outlet, and the second plate segment is parallel to the extension direction.

In some embodiments, a space between the medium inlet and the heat dissipation fins within the medium flow channel forms a distribution region, wherein a distribution structure is arranged within the distribution region, the distribution structure including a first distribution plate and a second distribution plate that are oppositely arranged in the width direction, wherein a distance between the first distribution plate and the second distribution plate in the width direction increases along a direction from the medium inlet towards the heat dissipation fins.

In some embodiments, end portions of the heat dissipation fins close to the distribution structure are flush, and are spaced apart from the distribution structure.

In some embodiments, the medium flow channel includes a plurality of sub-segments sequentially bent and connected, wherein a plurality of heat dissipation groups are arranged on each of the sub-segments along the extension direction, each of the heat dissipation groups including a plurality of said heat dissipation fins spaced apart in the width direction; and in a sub-segment where the distribution structure is disposed, a first distance between two heat dissipation groups of the plurality of heat dissipation groups close to the distribution structure is greater than a second distance between any other two adjacent heat dissipation groups of the plurality of heat dissipation groups, and a length of two heat dissipation groups of the plurality of heat dissipation groups closest to the distribution structure is less than a length of any other heat dissipation group of the plurality of heat dissipation groups.

In some embodiments, the medium flow channel includes channel side walls and channel end walls, the channel end walls including planar regions and inclined regions, wherein the planar regions are connected to the channel side walls via the inclined regions, and an end of each of the inclined regions connected to the channel side wall is inclined further away from the planar region than the other end of the inclined region; and the medium inlet and the medium outlet are respectively disposed on the planar regions of corresponding channel end walls.

In some embodiments, the medium flow channel includes a plurality of sequentially connected sub-segments, the plurality of sub-segments being juxtaposed in the width direction; and a thermally conductive strip is arranged on an outer surface of the housing corresponding to each of the sub-segments, wherein the thermally conductive strip is configured to be in contact with the chips, and an end of the confluence structure close to the heat dissipation fins extends into a region within the medium flow channel corresponding to the thermally conductive strip.

In a second aspect, embodiments of the present disclosure provide an electronic device. The electronic device includes a circuit board and the liquid cooling apparatus as described above; wherein the circuit board includes a plurality of chips, the plurality of chips being organized into a plurality of columns of chipsets arrayed along a width direction of a medium flow channel, and each of the chipsets including a plurality of said chips spaced apart along an extension direction of the medium flow channel; and the circuit board is mounted on at least one outer surface, facing away from the medium flow channel, of a housing of the liquid cooling apparatus, and each of the chips is in contact with a corresponding region of the medium flow channel.

In some embodiments, the medium flow channel includes a plurality of sub-segments juxtaposed in the width direction; and a plurality of columns of said chipsets are respectively in contact with regions on the housing where the sub-segments are disposed, and an end of a confluence structure close to a medium outlet extends out of a region within the medium flow channel corresponding to the chipsets while an end of the confluence structure close to the heat dissipation fins extends into the region within the medium flow channel corresponding to the chipsets.

In the liquid cooling apparatus according to the present disclosure, by arranging a flow confluence structure between the medium outlet and the heat dissipation fins, and by designing the distance between the two confluence plates of the confluence structure to increase along the direction from the medium outlet towards the heat dissipation fins (i.e., decreasing along the medium flow direction). The distances from each heat dissipation fin to the medium outlet increase from the center towards both sides. This means the change in distance between the two confluence plates in the present invention is consistent with the variation in the dimensions defining the distances from each of the heat dissipation fins to the medium outlet. This configuration thereby enables the sub-flows of the medium, once divided by the heat dissipation fins, to be substantially simultaneously in contact with the confluence structure; and a avoids significant disparities in the velocity reduction of each medium sub-flow that arise from differing spacing regions between the heat dissipation fins and the confluence structure. In other words, the velocity of each of the medium sub-flows is allowed to remain substantially uniform when reaching the confluence structure. Additionally, it is ensured that the velocity and temperature across the width of the entire medium flow channel are as uniform as possible, such that the heat dissipation effect for the various chips across the width of the medium flow channel is as consistent as possible, the problem of central chips having higher temperatures than those on the sides is avoided. In this way, the temperature uniformity of the heat-generating chips across the width is enhanced, the temperatures of the chips are lowered, the overall performance of the circuit board is improved, and the service life thereof is extended.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic structural view of a liquid cooling apparatus at one view angle according to some embodiments of the present disclosure;
FIG. 2 is schematic structural view of the liquid cooling apparatus illustrated in FIG. 1 at another view angle;
FIG. 3 is a schematic exploded view of a liquid cooling apparatus according to some embodiments of the present disclosure;
FIG. 4 is a schematic structural view of a base plate in a liquid cooling apparatus according to some embodiments of the present disclosure;
FIG. 5 is a partial front view of the base plate illustrated in FIG. 4 at a medium outlet according to some embodiments of the present disclosure;
FIG. 6 is a partial front view of the base plate illustrated in FIG. 4 at a medium outlet according to some embodiments of the present disclosure;
FIG. 7 is a schematic structural view of an electronic device according to some embodiments of the present disclosure;
FIG. 8 is a schematic exploded view of an electronic device according to some embodiments of the present disclosure;
FIG. 9 is a partial enlarged view of part I illustrated in FIG. 8;
FIG. 10 is a schematic partial sectional view of an electronic device according to some embodiments of the present disclosure; and
FIG. 11 and FIG. 12 are schematic diagrams illustrating detected temperatures of chips at a medium inlet and a medium outlet view in an electronic device according to some embodiments of the present disclosure.

### Reference numerals and denotations thereof:

10-liquid cooling apparatus; 11-housing; 111-base plate; 1111-partition strip; 1112-housing wall; 1113-positioning pillar; 112-cover plate; 1121-thermally conductive strip; 1122-positioning hole; 12-medium outlet; 13-medium inlet; 14-medium flow channel; 141-channel end wall; 1411-planar region; 1412-inclined region; 142-channel side wall; 143-channel bottom wall; 144-sub-segment; 145-connecting segment; 15-heat dissipation fin; 151-first connecting surface; 152-second connecting surface; 153-first gap region; 154-second gap region; 155-heat dissipation group; 16-confluence structure; 161-first confluence plate; 1611-first plate segment; 1612-second plate segment; 162-second confluence plate; 17-distribution structure; 171-first distribution plate; 172-second distribution plate;
20-circuit board; 21-substrate; 211-second mounting hole; 22-chip; and
30-spring screw.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "a plurality of," "more," or "a plurality of" refers to at least two unless otherwise specified.

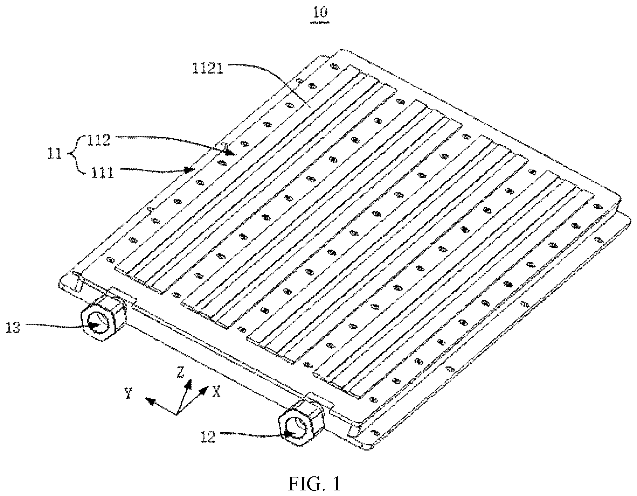

For convenience of description, a Cartesian coordinate system is established with an extension direction X, a width direction Y, and a depth direction Z of a medium flow channel in a liquid cooling apparatus. It should be noted that the extension direction X and the width direction Y of the medium flow channel described herein both refer to an extension direction of the medium flow channel at a described position. FIG. 1 merely shows an extension direction X and a width direction Y at a sub-segment 144. An extension direction at a connecting segment is a curved direction, and the width direction Y is a radial direction of the connecting segment 145. It should be noted that the establishment of this coordinate system is solely for convenience of description and does not impose specific limitations on the state of use of the liquid cooling apparatus. During use or placement, corresponding directions may be defined according to the actual orientation or operating state of the liquid cooling apparatus.

Some embodiments of the present disclosure provide a liquid cooling apparatus 10, which may be used for dissipating heat from chips of electronic devices. Specifically, when used for a supercomputing device (with a huge computation loads), the liquid cooling apparatus 10 dissipates heat from the components on a circuit board thereof. The electronic device includes the liquid cooling apparatus 10 and a circuit board 20. The liquid cooling apparatus 10 includes a housing 11. A medium flow channel is arranged within the housing 11. The circuit board includes a plurality of chips 22. The plurality of chips 22 are organized into a plurality of columns of chipsets arrayed along a width direction of the medium flow channel. Each of the chipsets includes a plurality of chips 22 spaced apart along an extension direction of the medium flow channel. The circuit board is mounted on at least one outer surface of the housing 11 that faces away from the medium flow channel, and each of the chips is in contact with a corresponding region of the medium flow channel.

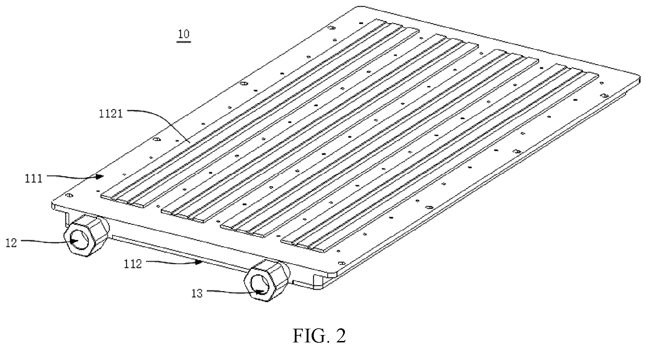

Referring to FIG. 1 to FIG. 6, the liquid cooling apparatus 10 includes a housing 11. A medium outlet 12, a medium inlet 13, and a medium flow channel 14 are arranged in the housing 11. The medium flow channel 14 is in communication with both the medium outlet 12 and the medium inlet 13. Within the medium flow channel 14, a plurality of heat dissipation fins 15 are spaced apart along a width direction Y of the medium flow channel 14. That is, two, three, or more heat dissipation fins are arranged in the width direction Y. Each of the heat dissipation fins 15 extends along an extension direction X of the medium flow channel 14, and hence divides the medium flow channel into a plurality of juxtaposed sub-flow channels. As a medium flows through, a plurality of medium sub-flows are formed, i.e., a portion of the medium flow flowing through a sub-flow channel forms medium sub-flows.

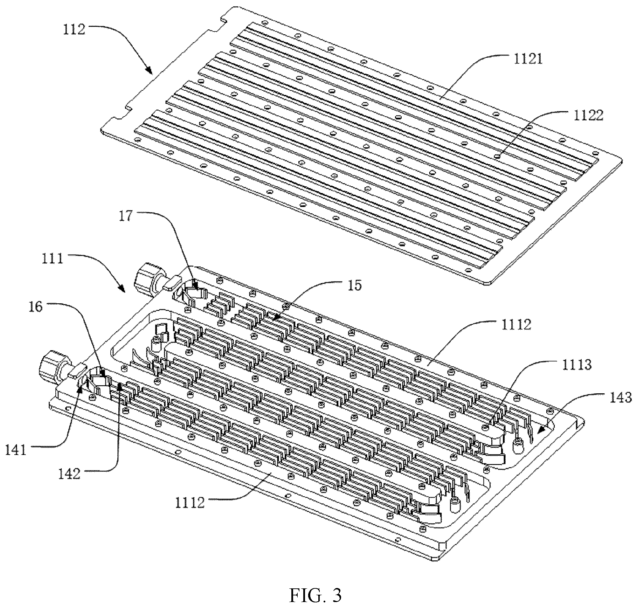

A space within the medium flow channel 14, disposed between the medium outlet 12 and the heat dissipation fins 15, forms a confluence region. That is, in the region of the medium flow channel 14 close to the medium outlet 12, the medium outlet 12, the confluence region, and the heat dissipation fins 15 are sequentially arranged along the extension direction X of the medium flow channel. The heat dissipation fins 15 are not immediately adjacent to the medium outlet 12, but a space is reserved between the heat dissipation fins 15 and the medium outlet 12. This space constitutes the confluence region. A confluence structure 16 is disposed within the confluence region. The confluence structure 16 includes a first confluence plate 161 and a second confluence plate 162 that are oppositely and spacedly arranged in the width direction Y. A distance between the first confluence plate 161 and the second confluence plate 162 in the width direction Y increases along a direction from the medium outlet 12 towards the heat dissipation fins 15. That is, this distance decreases along the direction of medium flow. As illustrated in FIG. 3 to FIG. 5, the first confluence plate 161 and the second confluence plate 162 are spaced apart from each other at all positions in the width direction Y, thereby forming a funnel-like (or trumpet-shaped) structure. An opening of the funnel-like structure is smaller at a first end of the confluence structure 16 close to the medium outlet 12 than at a second end close to the heat dissipation fins 15. That is, at the first end, a distance between the first confluence plate 161 and the second confluence plate 162 is smaller, and the two plates do not intersect on the side close to the medium outlet 12 but maintain this smaller distance; and at the second end, the distance between the first confluence plate 161 and the second confluence plate 162 is larger. Furthermore, in the extension direction X, the confluence structure 16 is spaced apart from the heat dissipation fins 15, and neither the first confluence plate 161 nor the second confluence plate 162 is immediately adjacent to the heat dissipation fins 15. When projected in the width direction Y, a projection of the confluence structure 16 does not overlap with a projection of the plurality of heat dissipation fins 15 (referring to the plurality of heat dissipation fins 15 that are proximate in the extension direction X), and a specific distance is maintained between the closest ends of the two projections. A distance of each of the heat dissipation fins 15 to the medium outlet 12 increases from a central portion towards both sides in the width direction Y. A distance is maintained between the confluence structure 16 and the heat dissipation fins 15. The end portions of the heat dissipation fins 15 close to the medium outlet 12 are not flush, and distances from ends of the heat dissipation fins 15 close to the medium outlet 12 to the second end of the confluence structure 16 (i.e., the end away from the medium outlet 12) are not equal. The distance is smallest for the heat dissipation fins disposed in the middle of the width direction Y, increases from the middle towards both sides, and is largest for the outermost heat dissipation fins on both sides.

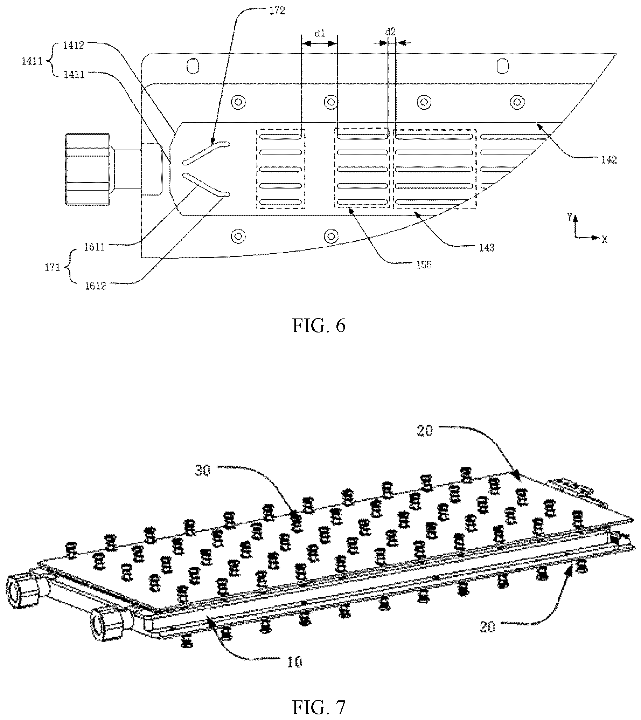

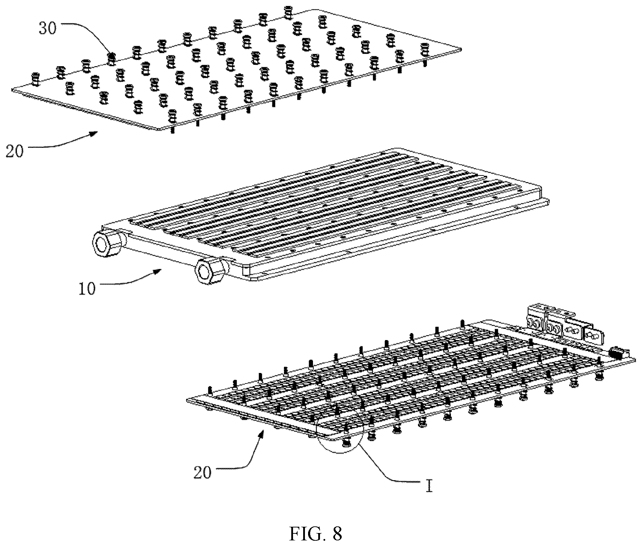

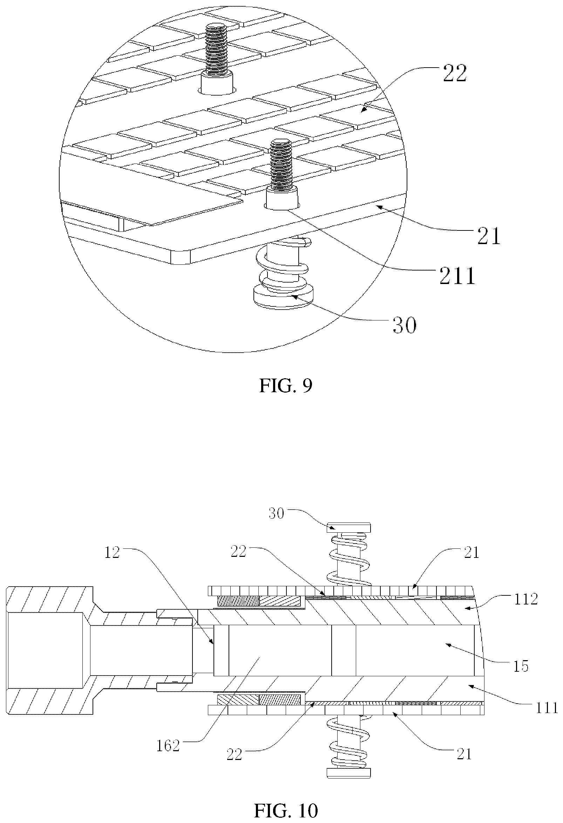

In the liquid cooling apparatus 10 according to the present disclosure, by arranging the confluence structure 16 between the medium outlet 12 and the heat dissipation fins 15, and by designing the distance between the two confluence plates (i.e., the first confluence plate and the second confluence plate) of the confluence structure 16 to increase along the direction from the medium outlet 12 towards the heat dissipation fins 15, while designing the distance of each of the heat dissipation fins 15 to the medium outlet 12 also increases from the middle towards both sides, the medium sub-flows, which pass through the sub-flow channels formed by the heat dissipation fins 15, still maintain, under the action of the confluence structure 16, flow velocity and temperature that are as uniform as possible across all position in the width direction Y of the medium flow channel 14 near the medium outlet 12. This ensures that the heat dissipation effect for each of the chips disposed at the same position in the width direction Y within the medium flow channel 14 is as similar as possible, thereby enhancing the temperature uniformity of the chips in the width direction Y. After the liquid cooling apparatus 10 is assembled with the circuit board 20 (refer to FIG. 7 to FIG. 10), the performance of the entire circuit board is improved, and the service life thereof is extended.

In some embodiments, although a confluence structure 16 is also arranged at the medium outlet 12, the ends of the heat dissipation fins 15 close to the medium outlet 12 are flush in such configurations. Due to the unequal distances from the end portions of the heat dissipation fins to the confluence structure, when the medium sub-flows exit the sub-flow channels formed by the heat dissipation fins 15, there is a significant disparity in the reduction of their flow velocities upon reaching the confluence structure 16. This leads to a problem, after the liquid cooling apparatus 10 is assembled with the circuit board 20, where chips on the circuit board 20, corresponding to the same position in the medium flow channel but distributed in the width direction, exhibit significantly higher temperatures in the middle compared to the sides. In contrast, in the present disclosure, the change in distance between the two confluence plates is consistent with the variation in the dimensions (i.e., distances) of the heat dissipation fins 15 to the medium outlet 12. This allows the various medium sub-flows, divided by the heat dissipation fins 15, to contact the confluence structure 16 substantially simultaneously. This avoids significant disparities in the reduction of flow velocities among the medium sub-flows, which would otherwise be caused by differing gap regions between the heat dissipation fins 15 and the confluence structure 16. That is, the flow velocities of the medium sub-flows are enabled to remain substantially uniform upon reaching the confluence structure 16. Therefore, the interaction between the confluence structure 16 and the heat dissipation fins close to the confluence structure can better enhance the temperature uniformity of the chips in the width direction Y of the medium flow channel 14. This effect is particularly prominent when a plurality of columns of chipsets are arranged in the width direction at the same position along the medium flow channel 14. Furthermore, a junction temperature benefit of 1°C to 2°C is achieved for the chips at the medium outlet. This reduces the temperature of each of the chips as much as possible, and improves the overall temperature uniformity across all chips on the entire circuit board improved by 40%. Additionally, through the non-flush arrangement of the end portions of the heat dissipation fins at the medium outlet, the junction temperature of the chips at the medium outlet is further reduced by 0.9°C or more.

Still referring to FIG. 1 to FIG. 5, the housing 11 includes a base plate 111 and a cover plate 112 that may be fitted together. A side of the base plate 111 facing the cover plate 112 (i.e., side oriented towards the cover plate 112) is inwardly recessed to form a recessed region. The cover plate 112 covers an open end of the recessed region. The recessed region, together with a corresponding portion on the cover plate 112, collectively defines the medium flow channel 14. An outermost peripheral wall of the medium flow channel 14 (i.e., housing wall described hereinafter) is configured to protrude relative to the recessed region. When the medium flow channel 14 includes a plurality of juxtaposed sub-segments (detailed hereinafter), a partition strip 1111 is formed between two adjacent sub-segments 144. The partition strip 1111 is also configured to protrude relative to the recessed region. That is, the partition strip1111 divides the medium flow channel 14 into a plurality of sub-segments. Specifically, the medium flow channel 14 includes interconnected channel end walls 141 and channel side walls 142. The channel side walls 142 are parallel to the extension direction X, and the channel end walls 141 are perpendicular to the extension direction and are connected to the channel side walls 142. Understandably, the medium flow channel 14 also includes a channel bottom wall 143 and a channel top wall (not illustrated). The channel top wall and the channel bottom wall 143 are oppositely arranged in a height direction. The channel end walls 141 and the channel side walls 142 are connected to the channel bottom wall 143 along an edge of the channel bottom wall 143, and are simultaneously connected to the channel top wall along an edge of the channel top wall. The confluence structure 16 (including the first confluence plate 161 and the second confluence plate 162) and the heat dissipation fins 15 may be connected to the channel bottom wall 143 and may be in contact with the channel top wall at the same time, or a gap may be defined between the confluence structure 16 and the heat dissipation fins 15 and the channel top wall 143. The heat dissipation fins 15 may also be directly arranged on the channel bottom wall 143, and may be in contact with the channel top wall, or a gap may be defined between the heat dissipation fins 15 and the channel top wall. The channel top wall may be disposed on the cover plate 112, and the channel bottom wall 143 may be disposed on the base plate 111 (i.e., the bottom wall of the recessed region). The channel end walls 141 and the flow channel side walls 142 may all be disposed on the base plate 111 (i.e., the side walls of the recessed region); or may be partially disposed on the base plate 111 and partially on the cover plate 112. That is, in the embodiments, a side of the cover plate 112 facing the base plate 111 is also inwardly recessed, thereby also forming a recessed region. The cover plate 112 and the base plate 111 may be connected by welding (e.g., brazing). After welding, the cover plate and the base housing form an integral structure. Simultaneously, solder fills the gaps between the cover plate 112 and the base plate 111, such that liquid does not leak, thereby enhancing the sealing performance of the cover plate 112 and the base plate 111 at all positions of the medium flow channel 14.

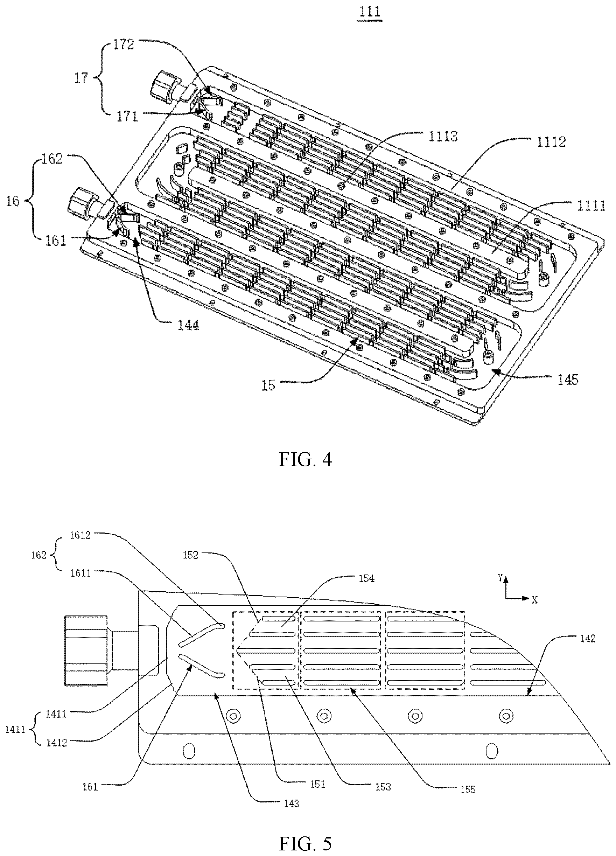

The channel end wall 141 may be a planar structure, which is smoothly connected to the channel side wall 142. In some embodiments, as illustrated in FIG. 5, the channel end wall 141 includes a planar region 1411 and an inclined region 1412. The planar region 1411 is connected to the channel side wall 142 via the inclined region 1412, and an end of the inclined region 1412 connected to the channel side wall 142 is inclined towards a side away from the planar region 1411, relative to the other end thereof. That is, a central portion of the channel end wall 141 in the width direction Y of the medium flow channel 14 is the planar region 1411, and edge portions are the inclined regions 1412. In the embodiments, the medium outlet 12 and the medium inlet 13 are respectively arranged on the planar regions 1411 of the corresponding channel end walls 141. By adding the inclined regions 1412, a guide effect is achieved for the medium flow, such that the confluence effect of the medium flow on the side of the medium outlet 12 is further enhanced, and the distribution effect of the medium flow at the medium inlet 13 is improved.

The medium flow channel 14 may include a plurality of sub-segments 144, and the sub-segments may be juxtaposed in the width direction Y and sequentially communicated. That is, these sub-segments 144 are connected in series, and an outlet end of one sub-segment serves as an inlet end of an adjacent other sub-segment. End portions of the first and last sub-segments 144 form the channel end walls 141. Alternatively, the plurality of sub-segments 144 may be connected at both ends. That is, these sub-segments are connected in parallel. An inlet end of each of the sub-segments is disposed on the same side and is in communication with the medium inlet 13, and an outlet end of each of the sub-segments is disposed on the same side and is communication with the medium outlet 12. The former is preferred, i.e., these sub-segments 144 are connected in series. In this way, uniformity of flow velocity within each of the sub-segments 144 is ensured, such that the uniformity of heat dissipation performance at various positions is enhanced. The plurality of sub-segments 144 may be arranged in parallel. In the embodiments, each of the sub-segments 144 may correspond to a plurality of columns of chipsets (detailed hereinafter), so as to simultaneously dissipate heat from a plurality columns of chipsets.

A gap is maintained between the medium outlet 12 and the first end of the confluence structure 16 close to the medium outlet 12, thereby forming a buffer zone. That is, the confluence structure 16 is not in contact with the channel end wall 141 of the medium flow channel 14. After flowing out of the confluence structure 16, the medium first passes through a buffer zone before reaching the medium outlet 12. In this way, an excessive impact force between the medium flow and the confluence structure 16 may be avoided as much as possible, thereby preventing turbulence at this position which could affect the heat dissipation performance, especially at high flow velocities. Similarly, the gap between the second end of the confluence structure 16 (away from the medium outlet 12) and the heat dissipation fins 15 may also avoid, as much as possible, turbulence that would affect heat dissipation performance.

The first confluence plate 161 and the second confluence plate 162 are respectively disposed on two opposite sides of a center plane of the medium flow channel 14 and are symmetrically distributed with respect to the center plane, forming a funnel-like (or trumpet-shaped) structure. The center plane of the medium flow channel 14 refers to a plane parallel to the extension direction X at a position thereof and passing through a centerline of the width direction Y of the medium flow channel 14.

In some embodiments, each of the first confluence plate 161 and the second confluence plate 162 includes a first plate segment 1611 and a second plate segment 1612 that are bent and connected. The first plate segment 1611 is obliquely arranged relative to the extension direction X. That is, one end of the first plate segment 1611 close to the medium outlet 12 is closer to the center plane of the medium flow channel 14 than the other end thereof. Furthermore, the first plate segment 1611 is closer to the medium outlet 12 than the second plate segment 1612. A distance between the two first plate segments 1611 gradually increases along the extension direction X, such that the two first plate segments 1611 form a structure with a smaller opening at the end close to the medium outlet 12 and a larger opening at the end away from the medium outlet 12. The two second plate segments 1612 are disposed at the position of the larger opening. The distance between the two second plate segments 1612 remains constant in the extension direction X. That is, the two second plate segments 1612 are arranged in parallel. Further, the two second plate segments 1612 are parallel to the extension direction X. In this way, the medium sub-flows passing through the heat dissipation fins 15 can first pass through the second plate segments 1612, which guide the medium flow more smoothly into the confluence structure 16. Subsequently, the two first plate segments 1611 further enhance the confluence effect. This can reduce the resistance to the medium flow as much as possible and avoid turbulence, thereby further improving the temperature uniformity of the chips in the width direction Y. In some embodiments, the first plate segment 1611 and the second plate segment 1612 have a smooth transition therebetween. In some embodiments, a length of the first plate segment 1611 is greater than a length of the second plate segment 1612, such that the medium flow has a sufficient confluence distance to achieve a better confluence effect. Each of the first confluence plate 161 and the second confluence plate 162 may also include only the first plate segment 1611.

Regardless of which of the above embodiments is adopted for the first confluence plate 161 and the second confluence plate 162, the first plate segment 1611 and the second plate segment 1612 may be planar plates or curved plates respectively. In embodiments where both the first confluence plate 161 and the second confluence plate 162 include only the first plate segment 1611, in a case where the first plate segment 1611 is a planar plate, then each of the confluence plates as a whole is a planar plate; and in a case where the first plate segment 1611 is a curved plate, then each confluence plate as a whole is a curved plate. The second plate segment 1612 is a planar plate. In embodiments where both the first confluence plate 161 and the second confluence plate 162 include the second plate segment 1612, in a case where the first plate segment 1611 is a planar plate, each of the confluence plates is a plate-like structure formed by the bending connection of two planar plates; and in a case where the first plate segment 1611 is a curved plate, each of the confluence plates is a plate-like structure formed by a combination of a curved plate and a planar plate. In embodiments where the first plate segment 1611 is a curved plate, it is preferred that the two curved plates of the first confluence plate 161 and the second confluence plate 162 protrude in directions facing away from each other. This reduces resistance to the medium flow, and enhances the heat dissipation effect.

In a case where the first plate segment 1611 is a planar plate, an included angle A between the two planar plates is 45° to 75°, for example, 45°, 50°, 55°*,* 60°, 65°, 70°, or 75°, or the like; or preferably, the included angle A is 60°. This ensures that the confluence structure 16 is capable of smoothly guiding the medium sub-flows through the confluence structure 16, and also minimizing impingement with the channel end wall 141 and hence preventing turbulence caused by flow channel changes at the confluence structure 16. When the distribution structure 17 (detailed hereinafter) is set at this included angle, the medium flow may be prevented from becoming overly dispersed when being guided, such that excessive impact of some medium flow against the channel side wall 142 which could generate bubbles is avoided, and the medium flow is allowed to better enter the sub-flow channels formed by the heat dissipation fins 15 after being distributed. In this way, resistance to the medium flow velocity is further reduced, and hence the heat dissipation effect of the entire liquid cooling apparatus is improved.

In some embodiments, each of the first confluence plate 161 and the second confluence plate 162 includes a first plate segment 1611 and a second plate segment 1612. The first plate segment 1611 is a planar plate. That is, the first plate segment 1611 is obliquely arranged relative to the extension direction X, and one end of the first plate segment 1611 close to the medium outlet 12 is closer to the center plane of the medium flow channel 14 than the other end thereof. By adopting this confluence structure 16, the medium flow achieves a better confluence effect immediately upon contact with the confluence structure 16, while simultaneously further reducing resistance to the medium flow. In this way, the heat dissipation uniformity for the chips is enhanced by increasing the flow velocity and improving the confluence effect.

For each of the first confluence plate 161 and the second confluence plate 162, an end face thereof closer to the medium port 12 is provided with rounded corners. For each of the first confluence plate 161 and the second confluence plate 162, the end face thereof has a smooth transition with two opposite side surfaces thereof. That is, the end face of the first flow guide plate 161 and the two flow guide surfaces thereof all have smooth transitions, and the end face of the second flow guide plate 162 and the two flow guide surfaces thereof all have smooth transitions. In this way, resistance against the medium flow is further reduced.

In all the above embodiments, end portions of the first confluence plate 161 and the second confluence plate 162 close to the medium outlet 12 directly face an interior of the medium outlet 12, and end portions of the first confluence plate 161 and the second confluence plate 162 close to the heat dissipation fins 15 are disposed outside both sides of the medium outlet 12. That is, when projected along the extension direction X, in the width direction Y, a projection of the first end of the confluence structure 16 close to the medium outlet 12 is at least partially within a projection of the medium outlet 12, while a projection of the second end (of the confluence structure 16) close to the heat dissipation fins 15 is entirely outside the projection of the medium outlet 12. That is, a projection of an end portion, close to the medium outlet 12, of each of the first confluence plate 161 and the second confluence plate 162 is at least partially within the projection of the medium outlet 12, and a projection of an end portion, away from the medium outlet 12, of each of the first confluence plate 161 and the second confluence plate 162 is disposed at least outside the projection of the medium outlet 12. For example, when the medium outlet 12 is a circular opening, a portion of the projection of the first end of the confluence structure 16 close to the medium outlet 12 is within the projection of the medium outlet 12. As another example, when the medium outlet is a square opening, the projection of the first end of the confluence structure 16 close to the medium outlet 12 may be entirely within the projection of the medium outlet 12.. In this way, resistance to the medium flow is reduced, such that the medium flow is allowed to more smoothly enter, at the second end of the confluence structure 16, respectively between the first confluence plate 161 and the second confluence plate 162, between the first confluence plate 161 and the channel side wall 142 on a side thereof, and between the second confluence plate 162 and the channel side wall 142 on its respective side. Furthermore, at the first end of the confluence structure 16, the medium flow is effectively guided into the medium outlet 12. This prevents a situation where, due to an excessively large distance between the edge heat dissipation fins 15 and the medium outlet 12, the medium flow between these fins and the channel side wall 142 is insufficient, and hence the heat dissipation effect at the edges of the medium flow channel 14 is not affected.

Furthermore, on a side of the confluence structure 16 closer to the medium port 111, a distance between the first confluence plate 161 and the second flow guide plate 162 is 1/3 to 1/2 of a maximum width of the medium outlet 12. That is, a minimum distance between the first confluence plate 161 and the second confluence plate 162 is 1/3 to 1/2 of the maximum width of the medium outlet 12, for example, 0.33 times, 0.34 times, 0.36 times, 0.38 times, 0.4 times, 0.43 times, 0.45 times, 0.48 times, or 0.5 times the maximum width of the medium outlet 12, so as to further improve the confluence effect of the confluence structure 16. The width of the medium outlet 12 refers to a dimension thereof in the width direction of the medium flow channel. For example, in a case where the medium outlet 12 is a circular hole, the maximum width thereof is a diameter of the circular hole.

Still referring to FIG. 4 and FIG. 5, end portions of the plurality of heat dissipation fins 15 close to the medium outlet 12 may be regularly arranged or irregularly arranged. A regular arrangement means, for example, that the end portions of the heat dissipation fins 15 disposed on the same side of the center plane of the medium flow channel 14 may be connected to form a planar surface or a curved surface, i.e., the connecting surface formed by connecting the end portions is a planar surface or a curved surface. An irregular arrangement means, for example, that the connecting surface formed by connecting the end portions of the heat dissipation fins 15 disposed on the same side of the center plane of the medium flow channel 14 is a bent surface; that is, what is formed after connecting the ends portions is a bent surface, where the bent surface refers to a non-smooth curved surface or a non-planar surface.

In some embodiments, the end portions of the heat dissipation fins 15 disposed on the same side of the center plane of the medium flow channel 14 and close to the medium outlet 12 connect to form a connecting surface (e.g., a first connecting surface 151, a second connecting surface 152). Each of the connecting surfaces is at least partially parallel to the confluence plate on the same side thereof. It is assumed that the connecting surface formed by connecting the end portions of the heat dissipation fins 15 disposed on the same side of the center plane as the first confluence plate 161 is denoted as the first connecting surface 151, and the connecting surface formed by connecting the end portions of the heat dissipation fins 15 disposed on the same side of the center plane as the second confluence plate 162 is denoted as the second connecting surface 152. Then, the first connecting surface 151 is at least partially parallel to the first confluence plate 161, and the second connecting surface 152 is at least partially parallel to the second confluence plate 162. For example, in embodiments where the first confluence plate 161 and the second confluence plate 162 includes only the first plate segment 1611, the first connecting surface 151 and the second connecting surface 152 are respectively parallel to the entire first confluence plate 161 and the entire second confluence plate 162. In embodiments where the first confluence plate 161 and the second confluence plate 162 both simultaneously include the first plate segment 1611 and the second plate segment 1612, the first connecting surface 151 and the second connecting surface 152 are respectively parallel to the first plate segment 1611 of the first confluence plate 161 and the second plate segment 1612 of the second confluence plate 162. In this way, the medium sub-flows exiting the sub-flow channels formed by the heat dissipation fins 15 may reach the confluence structure 16 after flowing substantially the same distance, i.e., reaching the confluence structure 16 substantially simultaneously. This further enhances the distribution effect of the entire medium flow in the width direction Y, and hence increases the heat dissipation uniformity of the liquid cooling apparatus in the width direction Y of the medium flow channel 14.

The plurality of heat dissipation fins 15 extend towards the medium outlet 12. Some heat dissipation fins 15 may intersect with the first confluence plate 161 or the second confluence plate 162. When projected along the extension direction X, projections of these heat dissipation fins 15 are disposed within a projection of the first confluence plate 161 or the second confluence plate 162, that is, there are overlapping regions with the projections of the heat dissipation fins 15 and the protection of the first confluence plate 161 or the second confluence plate 162. It is also possible that some heat dissipation fins 15, after extending, neither intersect with the first confluence plate 161 nor with the second confluence plate 162. When projected along the extension direction X, projections of these heat dissipation fins 15 have no overlapping region with a projection of either the first confluence plate 161 or the second confluence plate 162. For example, some heat dissipation fins 15 may pass through a small end opening of the first confluence plate 161 and the second confluence plate 162 close to the medium outlet 12. As another example, some heat dissipation fins 15 may pass directly outside the first confluence plate 161 and the second confluence plate 162.

Ends of the plurality of heat dissipation fins 15 close to the medium outlet 12 are not flush, and distances from the heat dissipation fins 15 to the second end of the confluence structure 16 are not equal. However, among those heat dissipation fins 15 that, through extension, may intersect with the first confluence plate 161 or the second confluence plate 162, their extension dimensions to the corresponding intersection positions are substantially uniform. That is, the differences between the extension dimensions are extremely small. In other words, these heat dissipation fins 15 intersect with the first confluence plate 161 or the second confluence plate 162 after extending towards the medium outlet 12 by their corresponding extension dimensions. In this way, the uniformity of flow velocity of the medium sub-flows exiting the heat dissipation fins 15 and reaching the confluence structure 16 is further increased, such that the distribution effect of the entire medium flow in the width direction Y is further enhanced.

Among the plurality of heat dissipation fins 15, adjacent two heat dissipation fins 15 disposed at an edge of the medium flow channel 14 in the width direction Y form a gap region (e.g., a first gap region 153, a second gap region 154) therebetween. Ends of the first confluence plate 161 and the second confluence plate 162 close to the heat dissipation fins 15 each face the gap region on their respective sides. As illustrated in FIG. 5, on a side of the center plane of the medium flow channel 14 where the first confluence plate 161 is disposed, a first gap region 153 is formed between two adjacent heat dissipation fins 15 disposed at the edge. On a side of the center plane of the medium flow channel 14 where the second confluence plate 162 is disposed, a second gap region 154 is formed between two adjacent heat dissipation fins 15 disposed at the edge. An end of the first confluence plate 161 close to the heat dissipation fins 15 faces the first gap region 153, and an end of the second confluence plate 162 close to the heat dissipation fins 15 faces the second gap region 154. When projected along the extension direction X, a projection of the end of the first confluence plate 161 close to the heat dissipation fins 15 is within a projection of the first gap region 153, and a projection of the end of the second confluence plate 162 close to the heat dissipation fins 15 is within a projection of the second gap region 154. By adopting this arrangement of the confluence plates and the heat dissipation fins 15, the medium flow may be better directed to converge towards the medium outlet 12, further increasing the heat dissipation uniformity in the width direction Y.

Referring to FIG. 3, FIG. 4, and FIG. 6, a space within the medium flow channel 14, disposed between the medium inlet 13 and the heat dissipation fins 15, forms a distribution region. A distribution structure 17 is arranged within the distribution region. The distribution structure 17 includes a first distribution plate 171 and a second distribution plate 172 that are oppositely arranged in the width direction Y. A distance between the first distribution plate 171 and the second distribution plate 172 in the width direction Y increases along an extension direction from the medium inlet 13 towards the heat dissipation fins 15. That is, at the medium inlet 13, the heat dissipation fins 15 are not immediately adjacent to the medium inlet 13 but a space is reserved between the heat dissipation fins 15 and the medium inlet 13. This space constitutes the distribution region. In other words, along the extension direction X of the medium flow channel 14, in the region close to the medium inlet 13, the medium inlet 13, the distribution region, and the heat dissipation fins 15 are sequentially arranged. The distribution structure 17 is disposed within the distribution region. As illustrated in FIG. 6, the first distribution plate 171 and the second distribution plate 172 of the distribution structure 17 are spaced apart from each other at all positions in the width direction Y, thereby forming a funnel-like (or trumpet-shaped) structure. An opening of the distribution structure 17 is smaller at a first end close to the medium inlet 13 than at a second end close to the heat dissipation fins 15. In this way, when the medium flow enters the medium flow channel 14, the medium flow first passes through the distribution structure 17 for initial distribution, and is then further distributed by the heat dissipation fins 15. This allows the flow velocity and temperature of the medium flow across all positions in the width direction Y of the medium flow channel to be substantially uniform starting from the medium inlet 13, thereby ensuring that the flow velocity and temperature at subsequent positions in the width direction are as equal as possible. This makes the medium flow smoother and better ensures that the heat dissipation performance at all positions in the width direction Y within the medium flow channel 14 is substantially uniform.

Specifically, the distribution structure 17 may adopt the structure according to any embodiment of the confluence structure 16. The difference lies in that along the direction of medium flow, the confluence structure 16 and the distribution structure 17 have opposite shapes. That is, the first end of the confluence structure 16 close to the medium outlet 12 corresponds to the end of the distribution structure 17 close to the medium inlet 13 (i.e., the first end of the distribution structure), and the second end of the confluence structure 16 close to the heat dissipation fins 15 corresponds to the end of the distribution structure 17 close to the heat dissipation fins 15 (i.e., the second end of the distribution structure). The structures of the first distribution plate 171 and the second distribution plate 172 within the distribution structure 17 may also adopt the structures of the first confluence plate 161 and the second confluence plate 162 according to any of the above embodiments of the confluence structure 16. Therefore, the specific internal structure of the distribution structure 17 is not described in further detail herein.

On the side close to the medium inlet 13, a gap is maintained between the medium inlet 13 and the distribution structure 17. That is, the distribution structure 17 is not in contact the channel end wall 141 of the medium flow channel 14. A gap is also maintained between the distribution structure 17 and the heat dissipation fins 15. These two spaced-apart gaps form buffer zones. When the medium flow enters the medium flow channel 14 from the medium inlet 13, the medium flow first passes through the buffer zone immediately adjacent to the medium inlet 13 before entering the distribution structure 17. After being distributed by the distribution structure 17, the medium flow first passes through the buffer zone immediately adjacent to the heat dissipation fins 15 before flowing through the heat dissipation fins 15. In this way, turbulence that may arise when the medium flow encounters changes in the flow channel structure is avoided as much as possible, such that the medium flow is allowed to smoothly enter the distribution structure 17. This enhances the velocity of the entire medium flow and improves the heat dissipation performance of the entire liquid cooling apparatus.

In the extension direction X, the plurality of heat dissipation fins 15 may form one heat dissipation group 155, or may be spaced apart form a plurality of heat dissipation groups 155. Each of the heat dissipation groups 155 includes a plurality of heat dissipation fins 15 spaced apart along the width direction Y. In embodiments where only one heat dissipation group 155 is formed, each of the heat dissipation fins 15 within this heat dissipation group extends from a position close to the confluence structure 16 to a position close to the distribution structure 17, and is arranged substantially along the entire length of the medium flow channel 14. In embodiments where a plurality of heat dissipation groups 155 are formed, as illustrated in FIG.s 5 and 6, each dashed box represents one heat dissipation group 155. A plurality of heat dissipation groups 155 are spaced apart along the extension direction X. Each of the heat dissipation groups 155 includes a plurality of heat dissipation fins 15 spaced apart in the width direction Y. Each of the heat dissipation fins 15 within each pf the heat dissipation groups is arranged only along a partial region of the medium flow channel 14. When the medium flow channel 14 includes a plurality of sub-segments 144 that are bent and connected, a plurality of heat dissipation groups 155 may also be arranged in each of the sub-segments 144. With the plurality of heat dissipation groups 155 spaced apart, the likelihood of the medium flow experiencing turbulence is reduced, thereby avoiding the impact of bubbles caused by turbulence on the heat transfer performance of the medium flow, and hence enhancing the heat dissipation performance of the entire liquid cooling apparatus. Furthermore, within each of the sub-segments, lengths of the heat dissipation groups 155 may be equal or not equal, and distances between any two adjacent heat dissipation groups may be equal or not equal.

In embodiments where a plurality of sub-segments 144 are arranged, the plurality of sub-segments 144 may be arranged in parallel. The medium flow channel 14 also includes a connecting segment 145 that connect each two adjacent sub-segments 144. In embodiments where a single set of heat dissipation groups is arranged, the heat dissipation fins 15 still extend and are connected through the connecting segments 145. In embodiments where a plurality of heat dissipation groups are arranged, heat dissipation groups 155 may also be arranged in the connecting segments 145, for example, only one group, two groups, or more groups. The number and length of the heat dissipation fins 15 in the heat dissipation groups 155 arranged in the connecting segments 145 may not be equal to those of the heat dissipation groups 155 disposed on the sub-segments 144. The heat dissipation groups 155 may also not be arranged in the connecting segments 145.

It should be noted that when a plurality of heat dissipation groups are arranged, the heat dissipation fins 15 on the side of the medium outlet 12, as mentioned previously and hereinafter, specifically refer to the heat dissipation fins 15 in the heat dissipation group closest to the medium outlet 12. For example, the distance between the heat dissipation fins 15 and the medium outlet 12 specifically refers to the distance between the heat dissipation fins 15 in the heat dissipation group closest to the medium outlet 12 and the medium outlet 12. Similarly, the heat dissipation fins 15 on the side of the medium inlet 13 may specifically refer to the heat dissipation fins 15 in the heat dissipation group closest to the medium inlet 13. For example, the distance between the heat dissipation fins 15 and the medium inlet 13 specifically refers to a distance between the respective heat dissipation fins 15 in the heat dissipation group closest to the medium inlet 13 and the medium inlet 13.

Ends of the plurality of heat dissipation fins 15 close to the distribution structure 17 are flush. That is, the structure of the ends of the plurality of heat dissipation fins 15 close to the distribution structure 17 is different from the structure of their ends close to the medium outlet 12 (or, in other words, close to the confluence structure 16). Regardless of whether only one heat dissipation group 155 is arranged or a plurality of heat dissipation groups 155 are arranged, on the side close to the distribution structure 17, the distances of the heat dissipation fins 15 to the medium inlet 13 are equal. This allows the medium flow, after being distributed by the distribution structure 17, to be better distributed at the heat dissipation fins 15, thereby further enhancing the distribution effect.

In embodiments where the medium flow channel 14 includes a plurality of sub-segments 144 sequentially bent and connected, and each of the sub-segments 144 is provided with a plurality of heat dissipation groups 155 along the extension direction X, in the sub-segment 144 where the distribution structure 17 is disposed, a first distance d1 between the two heat dissipation groups 155 close to the distribution structure 17 is greater than a second distance d2 between other adjacent two heat dissipation groups 155. Furthermore, the length of each of the two heat dissipation groups 155 closest to the distribution structure 17 is less than the length of any other heat dissipation group 155. In this way, turbulence in the medium flow near the vicinity of the heat dissipation fins 15 close to the medium inlet 13 is reduced. Additionally, by setting the first distance d1 and the second distance d2, and by reducing the lengths of the heat dissipation groups 155 at this position, the distribution effect is further enhanced, and hence the velocity of the entire medium flow is improved.

Furthermore, in the sub-segment 144 where the distribution structure 17 is disposed, a first length of the heat dissipation group 155 closest to the distribution structure 17 is less than a second length of the heat dissipation group 155 next closest to the distribution structure 17. The second length is less than or equal to a third length of other heat dissipation groups 155. Let the heat dissipation group 155 closest to the distribution structure 17 be denoted as the first heat dissipation group, the heat dissipation group 155 next closest to the distribution structure 17 be denoted as the second heat dissipation group, and other heat dissipation groups disposed in the sub-segment 144 where the distribution structure 17 is situated be denoted as the third heat dissipation group. Then, the length of the first heat dissipation group is the first length, the length of the second heat dissipation group is the second length, and the length of the third heat dissipation group is the third length, then the first length is less than the second length, and the second length is less than or equal to the third length. That is, the lengths of the first heat dissipation group, the second heat dissipation group, and the third heat dissipation group progressively increase. The length refers to a dimension in the extension direction X.

In embodiments where a plurality of heat dissipation groups 155 are arranged on each of the sub-segments 144, in sub-segments 144 other than those where the distribution structure 17 and the confluence structure 16 are disposed, the lengths of the heat dissipation groups 155 may be equal or not equal.

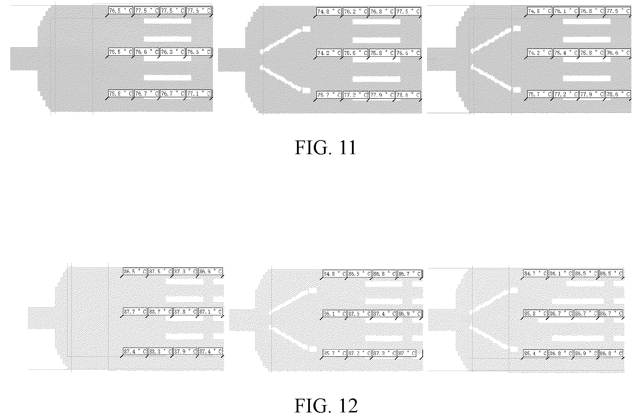

Considering the configuration of the entire medium flow channel 14, the arrangement of the confluence structure 16 and adjacent heat dissipation fins thereof at the medium outlet 12, as well as the arrangement of the distribution structure 17 and adjacent heat dissipation fins thereof at the medium inlet 13, better enhances the velocity of the entire medium flow and improves the distribution effect of the medium flow in the width direction Y. As illustrated in FIG. 11 and FIG. 12, which respectively display the temperature detection results for chips at the medium inlet 13 and the medium outlet 12, from left to right, are the temperature detection results for first embodiments, second embodiments, and third embodiments. In the first embodiments, only heat dissipation fins 15 are arranged within the medium flow channel, and the end portions of the heat dissipation fins close to both the medium inlet 13 and the medium outlet 12 are aligned. The second embodiments build upon the first embodiments by additionally providing both a distribution structure and a confluence structure within the medium flow channel. The third embodiments build upon the second embodiments by configuring the heat dissipation fins at the medium outlet according to the structure of the present application. As can be seen from the figures, the provision of the confluence structure 16 and the distribution structure 17, compared to a liquid cooling apparatus with only heat dissipation fins, results in a junction temperature benefit of 1-2°C for the chips 22 disposed near the medium outlet 12 and the medium inlet 13 in the width direction of the medium flow channel. This enhances the heat dissipation capability and improves the flow uniformity among the sub-flow channels. The temperature uniformity of the chips 22 across the entire circuit board is improved by 40%. Furthermore, through the arrangement of the heat dissipation fins 15 at the medium outlet 12, the chips 22 at the medium outlet 12 achieve an additional junction temperature benefit of 0.9°C in the width direction of the medium flow channel. Therefore, the present disclosure enhances the uniformity of the heat dissipation effect of the entire liquid cooling apparatus in the width direction of the medium flow channel. When the liquid cooling apparatus 10 is assembled with the circuit board 20, the temperature uniformity of the chips corresponding to the medium flow channel 14 in the width direction is better ensured, the temperature differences among the various chips on the circuit board are reduced, and heat dissipation capabilities are further enhanced. In this way, the performance is improved, and the service life of the entire circuit board is extended.

Still referring to FIG. 1 to FIG. 3, thermally conductive strips 1121 are protrudingly arranged on an outer surface of the housing 11 corresponding to each of the sub-segments 144, and the thermally conductive strips 1121 extend along the extension direction X. An end of the confluence structure 16 close to the heat dissipation fins 15 extends into a region within the medium flow channel 14 corresponding to the thermally conductive strips 1121. An end of the confluence structure 16 close to the medium outlet 12 is disposed on the side of the thermally conductive strips 1121 that is close to the medium outlet 12. When projected in the depth direction Z, a projection of the thermally conductive strips 1121 and a projection of the confluence structure 16 have an overlapping region. In this way, the medium flow may be made to primarily face the region corresponding to the thermally conductive strips 1121 at a position where its temperature is more uniform. Therefore, when the liquid cooling apparatus 10 is assembled with the circuit board 20, the thermally conductive strips 1121 are in contact with the chips, which may be direct contact or indirect contact via a thermal interface material (such as a thermal grease, a thermal gel, or a thermal pad). Therefore, the temperature uniformity of the chips on the circuit board 20 is improved.

The thermally conductive strips 1121 may be arranged on only one outer surface of the housing 11, or may be arranged on both outer surfaces of the housing 11, to increase the heat dissipation area of the liquid cooling apparatus 10 and enhance the overall heat dissipation efficiency. In embodiments where the housing 11 includes a base plate 111 and a cover plate 112, the thermally conductive strips 1121 may be arranged on an outer surface of the base plate 111 facing away from the cover plate 112 or on an outer surface of the cover plate 112 facing away from the base plate 111, or thermally conductive strips may be arranged on both these outer surfaces.

Some embodiments of the present disclosure further provide an electronic device. As illustrated in FIG. 7 to FIG. 10. The electronic device is used for processing data, information, or the like, which may be an electronic device designed for high computational loads, such as a supercomputing server, or may be any other data and information processing device. The electronic device includes a circuit board 20 and a liquid cooling apparatus 10. The circuit board 20 includes a plurality of chips 22. The liquid cooling apparatus 10 may be the liquid cooling apparatus 10 according to any of the above-described embodiments. The circuit board 20 is mounted on at least one outer surface, facing away from a medium flow channel 14 of the liquid cooling apparatus 10, of a housing 11 of the liquid cooling apparatus 10. For example, the circuit board 20 may be mounted only on a side of a cover plate 112 facing away from a base plate 111, or only on a side of the base plate 111 facing away from the cover plate 112, or circuit boards 20 may be mounted simultaneously on both these sides. This means two circuit boards 20 are configured. As illustrated in FIG. 7, the two circuit boards 20 and the liquid cooling apparatus 10 form a sandwich-like structure. In this way, the liquid cooling apparatus 10 dissipates heat for the circuit boards 20, thereby maintaining the temperature of the chips 22 on the circuit boards 20 as uniform as possible and enhancing the operational performance of the entire circuit boards 20.

Further, each of the chips 22 is in contact with the housing 11 (including direct contact and indirect contact), and corresponds to a region on the housing 11 where the medium flow channel 14 is disposed. That is, the medium flow channel 14 and the chips 22 are respectively disposed on two sides of the housing 11 in a depth direction Z of the medium flow channel 14. In this way, the heat conduction performance of the medium flow to the chips 22 is further enhanced.

The circuit board 20 also includes a substrate 21, and the chips 22 are arranged on a same side of the substrate 21. The plurality of chips 22 are arranged into a plurality of columns of chipsets arranged along the width direction Y. Each of the chipsets includes a plurality of chips 22 spaced apart along the extension direction X. Each column of chipsets is in contact with a region on the housing 11 where the medium flow channel 14 is arranged. In a case where the medium flow channel 14 is provided with a plurality of sub-segments 144, regions on the housing 11 where the sub-segments 144 are arranged respectively correspond to and are in contact with a plurality of columns of chipsets. In this case, each of the chipsets may be in contact with a region on the housing 11 where a sub-segment 144 is arranged, and one sub-segment 144 simultaneously corresponds to a plurality of columns of chipsets. Thus, each of the sub-segments 144 can simultaneously conduct heat for a plurality of columns of chipsets, thereby improving heat dissipation efficiency, and at the same time, ensuring that temperatures of these chipsets corresponding to the same sub-segment 144 in the width direction are kept as consistent as possible.

It is to be understood that the hash board 20 further includes a power supply interface 23 and a signal interface 24. The plurality of hash chips 22 are arranged on a same surface of the substrate 21 and are in contact with the liquid cooling plate 10. The power supply interface 23 and the signal interface 24 are arranged at a same edge of the substrate 21, and are both electrically connected to the hash chips 22, so as to supply power to and transmit signals for the hash chips 22.

A distance is maintained between each of the chipsets and both the medium outlet 12 and the medium inlet 13. Furthermore, an end of the confluence structure 16 close to the medium outlet 12 (i.e., the first end) extends out of a region within the medium flow channel 14 corresponding to the chipsets, while an end of the confluence structure 16 close to the heat dissipation fins 15 (i.e., the second end) extends into the region within the medium flow channel 14 corresponding to the chipsets. That is, when projected along a thickness direction of the housing 11, which is the depth direction Z of the medium flow channel 14, a projection of the confluence structure 16 and a projection of the chipset have an overlapping region. A projection of the first end of the confluence structure 16 is outside the projection of the chipset, specifically on the side of the chipset that is close to the medium outlet 12. By adopting this structure, inconsistent heat conduction to the chips 22, which could be caused by non-uniformity in the width direction Y at the medium outlet 12, is avoided, such that the medium flow is gradually in direct contact with the chips 22 only in a case where the medium flow is capable of filling the entire width direction Y of the medium flow channel 14. Therefore, the temperature uniformity of the chips 22 in the width direction within the same sub-segment 144 is further enhanced.

When both the first confluence plate 161 and the second confluence plate 162 include the second plate segment 1612, it is preferable that each of the chipsets extends at most into a portion of the first plate segment 1611 close to the second plate segment 1612. Preferably, the portion of the chipset extending into the confluence structure 16 faces the second plate segment 1612. By adopting this arrangement, the temperature uniformity of the chips 22 at the medium outlet 12 is further enhanced.

At the medium inlet 13, an end of the distribution structure 17 close to the medium inlet 13 extends out of a region within the medium flow channel 14 corresponding to the chipsets, while an end of the distribution structure 17 close to the heat dissipation fins 15 extends into the region within the medium flow channel 14 corresponding to the chipsets. That is, when projected along the depth direction Z of the medium flow channel 14, a projection of the distribution structure 17 and a projection of the chipset have an overlapping region. A projection of the end of the distribution structure 17 close to the medium inlet 13 is outside the projection of the chipset, specifically on the side of the chipset that is close to the medium inlet 13. By adopting this structure, inconsistent heat conduction to the chips 22, which could be caused by non-uniformity in the width direction Y at the medium inlet 13, is avoided, such that the medium flow is gradually in direct contact with the chips 22 at a position where the medium flow is capable of filling the entire width direction Y of the medium flow channel 14. Therefore, the temperature uniformity of the chips 22 in the width direction within the same sub-segment 144 is further enhanced.

Further, when both the first distribution plate 171 and the second distribution plate 172 include the second plate segment 1612, each of the chipsets extends at most into a portion of the first plate segment 1611 close to the second plate segment 1612. Preferably, the portion of the chipset extending into the distribution structure 17 faces the second plate segment 1612. By adopting this arrangement, the temperature uniformity of the chips 22 at the medium inlet 13 is further enhanced.

In embodiments where the housing 11 is provided with thermally conductive strips 1121, the plurality of columns of chipsets are in contact with the plurality of thermally conductive strips 1121 correspondingly. That is, each of the chips 22 is in contact with the housing 11 via a thermally conductive strip 1121. A thermal interface material, such as a thermal grease, a thermal gel, or a thermal pad, or the like may also be arranged between the chip 22 and the thermally conductive strip 1121 to further enhance the heat conduction efficiency and performance of the liquid cooling apparatus 10 for the circuit board. Specifically, on the side close to the medium outlet 12, an end face of the thermally conductive strip 1121 may be flush with an end face of the chipset, or the thermally conductive strip 1121 may extend beyond the chipset. That is, the thermally conductive strip 1121 is closer to the medium outlet 12 than the chipset.

The circuit board 20 and the liquid cooling apparatus 10 may be locked by screws, and may also be positioned by a positioning structure. In embodiments where the circuit board 20 is mounted on the side of the cover plate 112 facing away from the base plate 111, it is preferable that the circuit board 20, the cover plate 112, and the base plate 111 are secured by spring screws 30. While the cover plate 112 and the base plate 111 are connected by welding, the cover plate 112 and the base plate 111 may also be further connected by spring screws 30. Each of the spring screws 30 includes a spring, and an interconnected screw head and screw rod, with the spring sleeved over the exterior of the screw rod. Specifically, as illustrated in FIG. 3, FIG. 4, and FIG. 8 to FIG. 10, on the partition strip 1111 and on the two housing walls 1112 of the housing 11 in the width direction, a plurality of positioning pillars 1113 are respectively arranged along the extension direction X. A first mounting hole is arranged in each of the positioning pillars 1113. Positioning holes 1122 corresponding to the positioning pillars 1113 are arranged in the cover plate 112. Second mounting holes 211 corresponding to the first mounting holes are arranged in a substrate 21 of the circuit board 20. The cover plate 112 is fitted onto the base plate 111, such that the positioning pillars 1113 are in positioning engagement with the positioning holes 1122. The substrate 21 is secured to the base plate 111 by spring screws 30 passing through the second mounting holes 211 and engaging with the corresponding first mounting holes. That is, a plurality of positioning pillars 1113, a plurality of positioning holes 1122, a plurality of first mounting holes, and a plurality of second mounting holes 211 are in one-to-one correspondence. Both ends of the spring of each of the spring screws 30 are respectively abutted against the screw head and the substrate 21. In the embodiments, during assembly of the circuit board 20 and the liquid cooling apparatus 10, by adjusting a pressing force of the spring screws 30, not only is each of the chips 22 caused to be in close contact with the housing 11, thereby improving a heat dissipation effect; but also damage to the chips 22 caused by an excessive pressing force between the hash board 21 and the housing 11 is avoided, without adding an additional limiting structure between the housing 11 and the circuit board 20. Specifically, a plurality of spring screws 30 are respectively arranged on each of the partition strips 1111 and each of the housing walls 1112, so as to better enable each of the chips 22 and the housing 11 to be in close contact, and thereby improve heat dissipation performance of the electronic device.

A height of the positioning pillar 1113 is less than or equal to a thickness of the cover plate 112. In this way, the positioning pillar 1113 may not protrude from the side of the cover plate 112 facing away from the base plate 111, such that the assembly of the circuit board 20 is not affected by the positioning pillar 1113, and hence the flexibility of circuit board 20 assembly is enhanced. In the embodiments, an opening of the second mounting hole 211 in the circuit board 20 may be configured to be smaller than an opening of the positioning hole 1122, thereby achieving positioning of the circuit board 20 with respect to the housing 11 through the engagement of the second mounting hole 211, the screw rod of the spring screw 30, and the first mounting hole. In some embodiments, the opening of the second mounting hole 211 may also be configured to be the same as or larger than the opening of the positioning hole 1122. The screw rod of the spring screw 30 may be configured as a stepped shaft, with a larger diameter segment of the stepped shaft disposed between a smaller diameter segment and the screw head. The larger diameter segment is in an insertion fit with the second mounting hole 211, and the spring is sleeved over the exterior of the larger diameter segment.

The height of the positioning pillar 1113 may also be greater than the thickness of the cover plate 112. In this way, the positioning pillar 1113 protrudes from the cover plate 112, and the second mounting hole 211 on the circuit board 20 may be inserted over the positioning pillar 1113, so as to simultaneously position both the cover plate 112 and the circuit board 20 using the same positioning pillar 1113.

In embodiments where the circuit board 20 is mounted on a surface of the bottom plate 111 facing away from the cover plate 112, the circuit board 20 and the housing 11 may also be locked by spring screws 30. In the embodiments, the substrate 21 may be directly locked to the first mounting holes in the bottom plate 111 by passing through the second mounting holes 211 therein. Two ends of the spring of each of the spring screws 30 are respectively abutted against the screw head and the substrate 21. In embodiments where circuit boards 20 are respectively mounted on two sides of the housing 11, the first mounting holes in the base plate 111 may be through holes. In some other embodiments, the first mounting holes may also be configured as through holes.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid cooling apparatus applicable to an electronic device, the electronic device comprising a circuit board and the liquid cooling apparatus; wherein the liquid cooling apparatus comprises a housing, a medium inlet, a medium outlet, and a medium flow channel being arranged in the housing, wherein the medium flow channel is in communication with the medium inlet and the medium outlet, and a plurality of heat dissipation fins are spaced apart along a width direction of the medium flow channel within the medium flow channel, the heat dissipation fins extending along an extension direction of the medium flow channel; the circuit board comprises a plurality of chips, wherein the plurality of chips are organized into a plurality of columns of chipsets arrayed along the width direction, each of the chipsets comprising a plurality of said chips spaced apart along the extension direction; and the circuit board is mounted on at least one outer surface of the housing facing away from the medium flow channel, and each of the chips is in contact with a corresponding region of the medium flow channel; wherein
a space between the medium outlet and the heat dissipation fins within the medium flow channel forms a confluence region, wherein a confluence structure is arranged within the confluence region, the confluence structure comprising a first confluence plate and a second confluence plate oppositely and spacedly arranged in the width direction, wherein a distance between the first confluence plate and the second confluence plate increases along a direction from the medium outlet towards the heat dissipation fins; and
in the extension direction, the confluence structure is spaced apart from the heat dissipation fins, and a distance between each of the heat dissipation fins to the medium outlet increases from a central portion towards both sides in the width direction.

2. The liquid cooling apparatus according to claim 1, wherein end portions of the heat dissipation fins disposed on a same side of a center plane of the medium flow channel are connected to form a connecting surface, and the connecting surface is at least partially parallel to a confluence plate on a same side of the connecting surface.

3. The liquid cooling apparatus according to claim 1, wherein among the plurality of heat dissipation fins, two adjacent heat dissipation fins disposed at an edge of the medium flow channel in the width direction form a gap region therebetween; and ends of the first confluence plate and the second confluence plate close to the heat dissipation fins each face the gap region on their respective sides.

4. The liquid cooling apparatus according to claim 1, wherein end portions of the first confluence plate and the second confluence plate close to the medium outlet directly face an interior of the medium outlet, and end portions of the first confluence plate and the second confluence plate close to the heat dissipation fins are disposed outside both sides of the medium outlet.

5. The liquid cooling apparatus according to claim 1, wherein each of the first confluence plate and the second confluence plate comprises a first plate segment and a second plate segment that are bent and connected, wherein the first plate segment is obliquely arranged relative to the extension direction and is closer to the medium outlet, and the second plate segment is parallel to the extension direction.

6. The liquid cooling apparatus according to claim 1, wherein a space between the medium inlet and the heat dissipation fins within the medium flow channel forms a distribution region, wherein a distribution structure is arranged within the distribution region, the distribution structure comprising a first distribution plate and a second distribution plate that are oppositely arranged in the width direction, wherein a distance between the first distribution plate and the second distribution plate in the width direction increases along a direction from the medium inlet towards the heat dissipation fins.

7. The liquid cooling apparatus according to claim 6, wherein end portions of the heat dissipation fins close to the distribution structure are flush, and are spaced apart from the distribution structure.

8. The liquid cooling apparatus according to claim 7, wherein the medium flow channel comprises a plurality of sub-segments sequentially bent and connected, wherein a plurality of heat dissipation groups are arranged on each of the sub-segments along the extension direction, each of the heat dissipation groups comprising a plurality of said heat dissipation fins spaced apart in the width direction; and
in a sub-segment where the distribution structure is disposed, a first distance between two heat dissipation groups of the plurality of heat dissipation groups close to the distribution structure is greater than a second distance between any other two adjacent heat dissipation groups of the plurality of heat dissipation groups, and a length of two heat dissipation groups of the plurality of heat dissipation groups closest to the distribution structure is less than a length of any other heat dissipation group of the plurality of heat dissipation groups.

9. The liquid cooling apparatus according to any one of claims 1 to 8, wherein the medium flow channel comprises channel side walls and channel end walls, the channel end walls comprising planar regions and inclined regions, wherein the planar regions are connected to the channel side walls via the inclined regions, and an end of each of the inclined regions connected to the channel side wall is inclined further away from the planar region than the other end of the inclined region; and
the medium inlet and the medium outlet are respectively disposed on the planar regions of corresponding channel end walls.

10. The liquid cooling apparatus according to any one of claims 1 to 9, wherein the medium flow channel comprises a plurality of sequentially connected sub-segments, the plurality of sub-segments being juxtaposed in the width direction; and
a thermally conductive strip is arranged on an outer surface of the housing corresponding to each of the sub-segments, wherein the thermally conductive strip is configured to be in contact with the chips, and an end of the confluence structure close to the heat dissipation fins extends into a region within the medium flow channel corresponding to the thermally conductive strip.

11. An electronic device, comprising: a circuit board and the liquid cooling apparatus as defined in any one of claims 1 to 10; wherein the circuit board comprises a plurality of chips, the plurality of chips being organized into a plurality of columns of chipsets arrayed along a width direction of a medium flow channel, and each of the chipsets comprising a plurality of said chips spaced apart along an extension direction of the medium flow channel; and the circuit board is mounted on at least one outer surface, facing away from the medium flow channel, of a housing of the liquid cooling apparatus, and each of the chips is in contact with a corresponding region of the medium flow channel.

12. The electronic device according to claim 11, wherein the medium flow channel comprises a plurality of sub-segments juxtaposed in the width direction; and
a plurality of columns of said chipsets are respectively in contact with regions on the housing where the sub-segments are disposed, and an end of a confluence structure close to a medium outlet extends out of a region within the medium flow channel corresponding to the chipsets while an end of the confluence structure close to the heat dissipation fins extends into the region within the medium flow channel corresponding to the chipsets.
